# EUROPEAN PATENT SPECIFICATION

(11) **EP 1 755 202 B1**
(45) Date of publication and mention of the grant of the patent: **29.12.2010**
(21) Application number: 06017085.9
(22) Date of filing: 16.08.2006
(51) Int. Cl.: H01R 43/02

(54) **A connector, a terminal fitting, a chained terminal and a mounting method for a connector**
Verbinder, Anschlusskontakt, Trägerstreifen mit Kontakt und Verfahren zum Montieren eines Verbinders
Connecteur, organe de contact, bande de terminaux électriques et procédé de montage d'un connecteur

(30) Priority: 18.08.2005 JP 2005237310; 14.09.2005 JP 2005266747
(43) Date of publication of application: 21.02.2007
(73) Proprietor: Sumitomo Wiring Systems, Ltd., Yokkaichi-city, Mie 510-8503 (JP)
(72) Inventor: Aihara, Tetsuya, Yokkaichi-City Mie 510-8503 (JP)
(74) Representative: Müller-Boré & Partner Patentanwälte

(56) References cited:
- WO-A-98/06149
- DE-A1- 19 907 427
- US-A- 4 737 115
- US-A- 5 241 134
- US-A1- 2003 034 169
- US-A1- 2003 134 530

## Description

The present invention relates to a connector for an electric or electronic device, in particular to a circuit board connector, to a terminal fitting therefor, to chained terminals and to a method of mounting a connector to an electric or electronic device such as a printed circuit board.

One example of a circuit board connector is known from Japanese Unexamined Patent Publication No. H11-265765. This connector is provided with a housing to be fixed to a circuit board, and a plurality of terminal fittings are mounted in the housing by being pressed thereinto. One side of each terminal fitting serves as a terminal connecting portion projecting into a housing to be electrically connectable with a mating terminal, whereas the other side thereof serves as a board connecting portion drawn out of the housing and connectable with a conductor on the outer surface of the circuit board by soldering.

Whether or not solder connection at the board connecting portions is good is tested by eye, for example, by looking at the height of solder adhered to the rear end surfaces (extending end surfaces) of the board connecting portions in a usual practice. The reason why the rear end surfaces of the board connecting portions are used as testing surfaces is that the solder adhered to parts of the board connecting portions other than the rear end surfaces cannot be seen by an testing person by being hidden behind the adjacent terminal fittings and/or the housing.

Plating such as tin plating is applied to the outer surfaces of such terminal fittings, whereby the terminal connecting portions can be better held in close contact with the mating terminal fittings to improve contact reliability and, on the other hand, affinity to the solder is improved at the board connecting portions to enable satisfactory soldering.

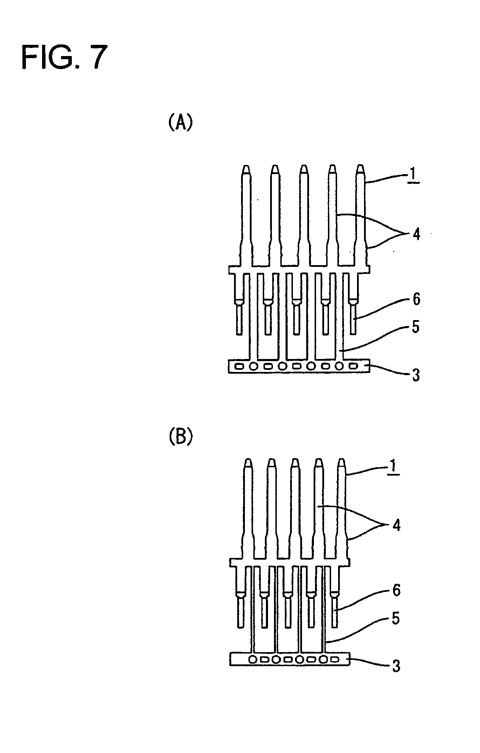

Upon producing terminal fittings as shown in FIG. 7(A), an electrically conductive metal sheet is punched to obtain chained terminals 1 in which a plurality of terminal fittings 4 (specifically, terminal fitting pieces) project side by side from one lateral edge of a carrier 3 in the form of a long strip. In the chained terminals 1, board connecting portions 6 are arranged adjacent to coupling portions 5 for coupling the terminal fittings 4 to the carrier 3, and the rear end surfaces thereof are exposed. If the above plating is applied to the chained terminals, metal films are also formed on the exposed rear end surfaces of the board connecting portions 6, i.e. solder testing surfaces, which makes the solder test more reliable.

However, in the above construction, the board connecting portions 6 need to be juxtaposed in addition to the coupling portions 5, which accordingly widens intervals between the terminal fittings 4. If an attempt is made, as a countermeasure, to narrow the intervals between the terminal fittings 4 with the board connecting portions 6 kept juxtaposed as shown in FIG. 7(B), the coupling portions 5 become narrower, wherefore the press work is made difficult due to insufficient strength of the coupling portions 5. As a result, there are problems that the intervals between the terminal fittings 4 can be substantially narrowed, making the further miniaturization difficult and leading to a higher cost.

Moreover in the above case, the solder applied to the conductors only adheres to the lower surfaces to the opposite side surfaces of the board connecting portions. Thus, if a tensile force acts on the board connecting portions in an upward direction away from the circuit board, it has been difficult to securely suppress upward (pulling direction) displacements of the board connecting portions. This may cause the board connecting portions to be detached from the conductors, thereby impairing connection reliability.

WO-A-9806149 discloses an electrical connector having thin contacts with surface mount edges. Contact leads include a recess in an edge portion which provides a receptacle for solder during the surface mount solder attachment.

US2003/0134530 discloses a terminal leg on connector for soldering purpose comprisinq an outermost end on which at least one downward and outward inclined slope or at least one groove is formed.

US-A-5241134 discloses terminals of surface mount components comprising solder relief terminals, as e.g. solder relief holes, notches, grooves or ridges.

The present invention was developed in view of the above problems, and an object thereof is to improve overall operability of a connector to be mounted to an electric or electronic device such as a printed circuit board.

This object is solved according to the invention by the features of the independent claims. Preferred embodiments of the invention are subject of the dependent claims.

According to the invention, there is provided a connector according to claim 1.

According to a preferred embodiment of the invention, the recessed portions comprise one or more solder testing portions having upward-sloped slants to which solder applied to the conductors is to be at least partly adhered are formed at lateral edge portions of the device connecting portions, the height of the upper surface of the solder is to be defined within a height range of the slants, and an adhered state of the solder to the slants can be seen from the outside.

Accordingly, the miniaturization and lower cost of terminal fittings is realized by enabling an operation of punching out terminal fittings spaced apart at narrower intervals thereby improving overall operability of the connector.

According to a further preferred embodiment of the invention, there is provided a circuit board connector, comprising:
a housing to be fixed to a circuit board, and
terminal fittings to be mounted in the housing, each terminal fitting including a board connecting portion at a part thereof drawn out of the housing, the board connecting portion being arranged along the outer surface of the circuit board and connected with a corresponding conductor on the circuit board by soldering,
wherein solder testing portions having upward-sloped slants to which solder applied to the conductors is adhered are formed at lateral edge portions of the board connecting portions, the height of the upper surface of the solder is defined within a height range of the slants, and an adhered state of the solder to the slants can be seen from the outside.

Accordingly, the miniaturization and lower cost of terminal fittings is realized by enabling an operation of punching out terminal fittings spaced apart at narrower intervals.

After the device or board connecting portions of the terminal fittings are connected with the conductors of the electric or electronic device such as the circuit board by soldering, a test may be conducted as to whether or not the solder connection at the board connecting portions is satisfactory. This test is conducted by seeing or detecting the adhered state of the solder to at least part of the slants of the solder testing portions at the lateral edge portions of the device (board) connecting portions. Since the solder test is not conducted by utilizing the extending end surfaces of the device (board) connecting portions, it is not necessary to apply plating to the extending end surfaces of the device (board) connecting portions. Then, testing is not hindered even if coupling portions for coupling the terminal fittings to the carrier include parts to serve as the device (board) connecting portions upon forming chained terminals in the production process of the terminal fittings and the coupling portions may be cut after plating is applied, preferably leaving the extending end surfaces of the device (board) connecting portions as unplated surfaces. Therefore, it is not necessary to juxtapose the device (board) connecting portions in addition to the coupling portions. As a result, it becomes possible to punch the terminal fittings at narrower intervals, enabling the realization of the miniaturization and lower cost of the terminal fittings.

Preferably, the solder testing portions are formed by making oblique cuts in the lateral edge portions of the device (board) connecting portions, and the inner surfaces of the cuts serve as the slants.

As one of the two possibilities of the invention, the notches are made by obliquely striking the lateral edge portions of the device (board) connecting portions from above, whereby the solder testing portions having oblique cuts can be easily formed. Further, the adhered state of the solder to the inner surfaces (slants) of the cuts can be precisely graphed by being seen.

Further preferably, the bottom edges of the slants in the solder testing portions substantially extend up to the lower surfaces of the board connecting portions.

Since the bottom edges of the slants in the solder testing portions extend substantially up to the lower surfaces (i.e. the surfaces substantially facing the printed circuit board K) of the board connecting portions, a contact area of the slants and the solder increases, wherefore the board connecting portions can be securely fixed to the circuit board. Further, no solder is adhered to the bottom edges of the slants unless plating is applied, judgment can be made as to whether plating has been already applied or not.

Further preferably, slants of the recessed portions are be colored in such a color having a clear contrast with the solder.

The recessed portion is formed by striking a corner portion of the device connecting portions from an oblique lateral side.

Further preferably, slants of the recessed portion are substantially symmetric with respect to forward and backward directions.

Most preferably, the recessed portion is formed with a cut-in line extending obliquely to a normal vector of the circuit board's surface and sloped up along directions away from the cut-in line.

According to a further preferred embodiment of the invention, the recess portions comprise one or more recesses provided on the surface of the device connecting portion substantially opposite to the surface to be faced to the electric or electronic device.

Accordingly, a connection reliability between board connecting portions and conductors is advantageously secured thereby improving overall operability of the connector.

When the board connecting portions are connected with the conductors on the circuit board by soldering, the solder flows into the recesses formed in the upper surfaces of the board connecting portions. Since an upward tensile force acting on the board connecting portions can be resisted by the solder flown into the recesses, detachments of the board connecting portions form the conductors can be prevented.

Preferably, the recesses extend across the upper surfaces of the device (board) connecting portions and make openings in side surfaces at the substantially opposite sides of the upper surfaces.

Since the solder flown into the recesses adheres to stretch between the opposite side surfaces of the device (board) connecting portions in the recesses, thereby forming bridges, the device (board) connecting portions are held onto the electric or electronic device such as the circuit board (conductors) with enhanced force.

As another of the two possibilities of the invention, the recesses are formed by striking the upper surfaces of the device (board) connecting portions substantially from above.

The recesses can be easily processed by striking the upper surfaces of the board connecting portions to make cuts.

According to the invention, there is further provided a terminal fitting according to claim 10.

According to a preferred embodiment of the invention, the recessed portion comprises one or more solder testing portions having upward-sloped slants to which solder applied to the conductors is to be at least partly adhered, the solder testing portions being formed at lateral edge portions of the device connecting portions, the height of the upper surface of the solder is to be defined within a height range of the slants, and an adhered state of the solder to the slants can be seen from the outside.

Preferably, the recess portions comprise one or more recesses provided on the surface of the device connecting portion substantially opposite to the surface to be faced to the electric or electronic device.

According to the invention, there are further provided chained terminals comprising a carrier extending and a plurality of terminal fittings according to one or more of the invention or a preferred embodiment thereof, which project substantially side by side from at least one lateral edge of the carrier

According to the invention, there is further provided a method of mounting a connector, in particular according to the invention or a preferred embodiment thereof, to an electric or electronic device such as a printed circuit board, comprising the following steps:
providing a housing to be fixed to an electric or electronic device such as a circuit board;
at least partly mounting one or more terminal fittings in the housing, each terminal fitting including a device connecting portion at a part thereof drawn out of the housing;
at least partly arranging the device connecting portion substantially along the outer surface of the electric or electronic device;
connecting the device connecting portion with a corresponding conductor on the electric or electronic device by soldering thereby at least partly applying solder to one or more recessed portions of the device connecting portion; and
forming the recessed portions buy striking a corner portion of the device connecting portions from an oblique lateral side or by striking the upper surfaces of the device connecting portions substantially from above.

According to a preferred embodiment of the invention, in the connecting step solder is applied to one or more solder testing portions of the recessed portion having upward-sloped slants formed at lateral edge portions of the device connecting portions, the height of the upper surface of the solder being defined within a height range of the slants.

Preferably, the method further comprises a step of inspecting an adhered state of the solder to the recessed portion, preferably to the slants.

Most preferably, in the soldering step solder applied to the conductors is guided at least partly into one or more recesses of the recessed portion(s), the recesses being formed in upper surfaces of the device connecting portions, preferably so as to extend substantially across the upper surfaces of the device connecting portions and make openings in side surfaces at the substantially opposite sides of the upper surfaces.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a perspective view of a circuit board connector according to one preferred embodiment,
FIG. 2 is a front view of the circuit board connector,
FIG. 3 is a side view of the circuit board connector,
FIG. 4 is an enlarged perspective view of a board connecting portion having solder adhered thereto,
FIG. 5 is a plan view of the board connecting portion having the solder adhered thereto,
FIG. 6 is a plan view of chained terminals,
FIG. 7(A) is a plan view of conventional chained terminals and FIG. 7(B) is a plan view of other conventional chained terminals,
FIG. 8 is a perspective view of a circuit board connector according to one further preferred embodiment,
FIG. 9 is a front view of the circuit board connector,
FIG. 10 is a side view of the circuit board connector,
FIG. 11 is an enlarged perspective view of a board connecting portion having solder adhered thereto,
FIG. 12 is an enlarged plan view of the board connecting portion having the solder adhered thereto, and
FIG. 13 is an enlarged section showing a state of the solder flown into a recess.

### <First Embodiment>

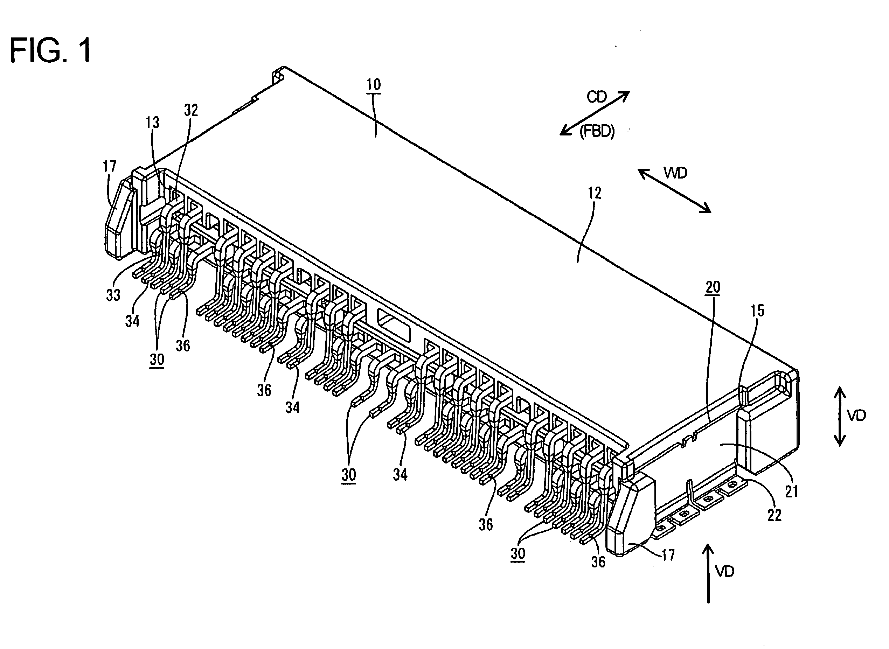

A first preferred embodiment of the present invention is described with reference to FIGS. 1 to 6. A circuit board connector (as a preferred connector for an electric or electronic device) of this embodiment is provided with one or more, preferably a plurality of terminal fittings 30 and a housing 10 in which the respective terminal fittings 30 are at least partly mounted. The housing 10 is fixed or mounted or mountable to a circuit board K (printed-wiring board as a preferred electric or electronic device) and is connectable with an unillustrated mating housing. In the following description, a side to be connected with the mating housing is referred to as a front side concerning forward and backward directions FBD, and reference is made to FIGS. 1 to 3 concerning vertical direction VD.

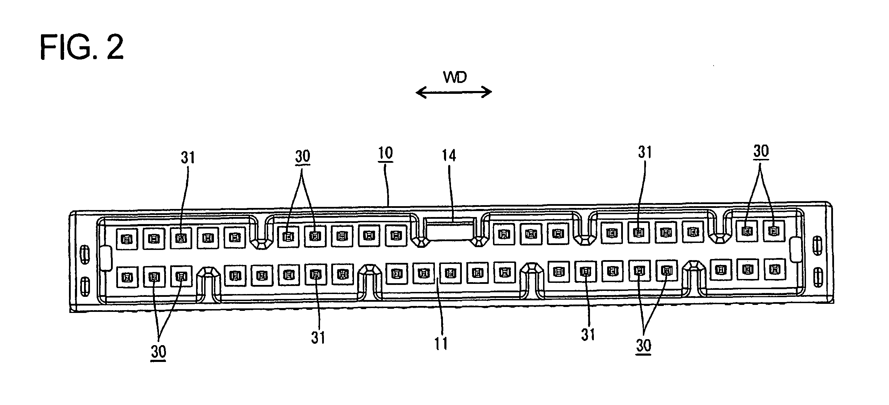

As shown in FIGS. 1 and 2, the housing 10 is made e.g. of a synthetic resin material to substantially have a laterally long shape as a whole and comprised of a terminal holding portion 11 for holding the one or more terminal fittings 30 and a receptacle 12 projecting from or near the peripheral edge of the terminal holding portion 11. The terminal holding portion 11 is formed with one or more, preferably a plurality of terminal insertion holes 13 through which the terminal fittings 30 are at least partly insertable from an insertion direction, preferably substantially from behind. The respective terminal insertion holes 13 are arranged substantially side by side in width direction WD at one or more stages, preferably at two (upper and lower) stages.

The receptacle 12 preferably is substantially in the form of a rectangular tube having an open front side, and is at least partly fittable into the mating housing substantially along the connecting direction CD or from front. A lock portion 14 engageable with a lock arm of the mating housing to hold the two housings connected is formed to project substantially down (inward) at an intermediate widthwise position (preferably at a substantially widthwise middle position) of the outer (upper) part of the receptacle 12.

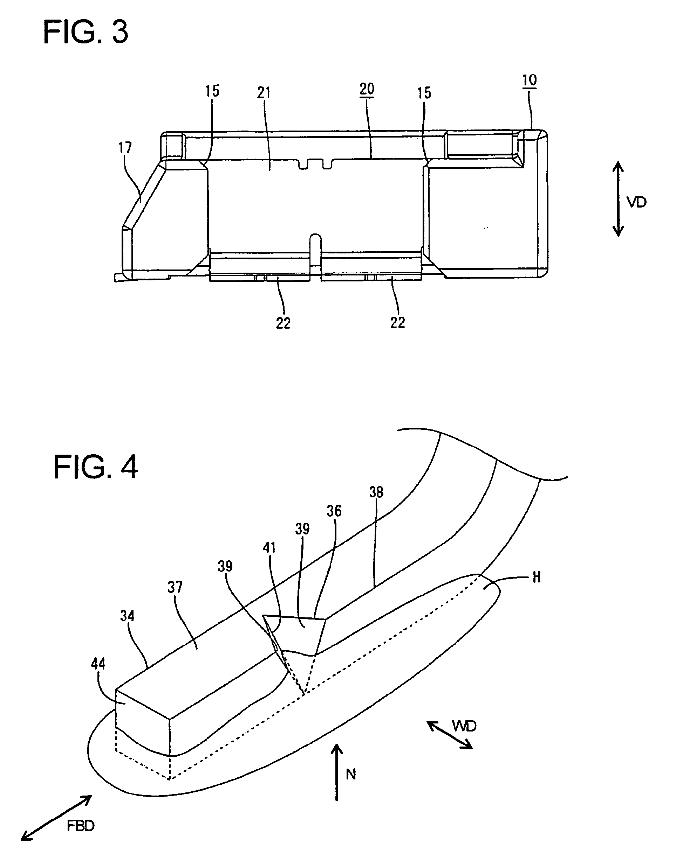

One or more, preferably a pair of mounting grooves 15 into which one or more fixing members 20 for fixing the housing 10 to the circuit board K are provided at the (preferably substantially opposite) widthwise end(s) of the receptacle 12. Each fixing member 20 preferably is made of a metal plate separate from the housing 10 and bent or substantially L-shaped as a whole preferably by having a main portion 21 in the form of a substantially flat plate extending substantially in vertical direction VD and a mounting portion (preferably comprising a solder portion 22) projecting sideways at an angle different from 0° or 180°, preferably substantially normal or substantially in width direction WD from the bottom end of the main portion 21 as shown in FIG. 3. The main portion 21 is insertable substantially along a mounting direction MD (preferably substantially along vertical direction VD) into the mounting groove 15 along the plate surface thereof, and the mounting portion (preferably the solder portion 22) can be fixed to the circuit board K (preferably by soldering) while being arranged along or on the outer surface of the circuit board K.

Each terminal fitting 30 preferably is formed by bending a rectangular bar member made of of a conductive material (such as metal) and preferably having a substantially rectangular cross section, and is comprised of a terminal connecting portion 31 projecting substantially forward from the front surface (connection surface) of the terminal holding portion 11, a substantially horizontal portion 32 projecting substantially parallel to the surface of the circuit board K and/or substantially horizontally backward from the rear surface of the terminal holding portion 11, a vertical portion 33 extending at an angle different from 0° or 180°, preferably substantially normal to the surface of the circuit board K and/or downward at an angle different from 0° or 180°, preferably substantially at right angle from the rear end of the horizontal portion 32, and a board connecting portion 34 (as a preferred device connecting portion) bent at the bottom or distal end of the vertical portion 33 to extend substantially parallel to the surface of the circuit board K and/or substantially horizontally e.g. substantially backward. The terminal connecting portions 31 are arranged while being at least partly surrounded by the receptacle 12, and are electrically connectable with mating terminals at least partly accommodated in the mating housing. The horizontal portions 32, the vertical portions 33 and the board connecting portions 34 are all arranged while being at least partly exposed outside the housing 10, wherein the board connecting portions 34 preferably are arranged substantially along the outer surface of the circuit board K and electrically connectable with conductors (conductor paths) printed or provided on the circuit board K by soldering.

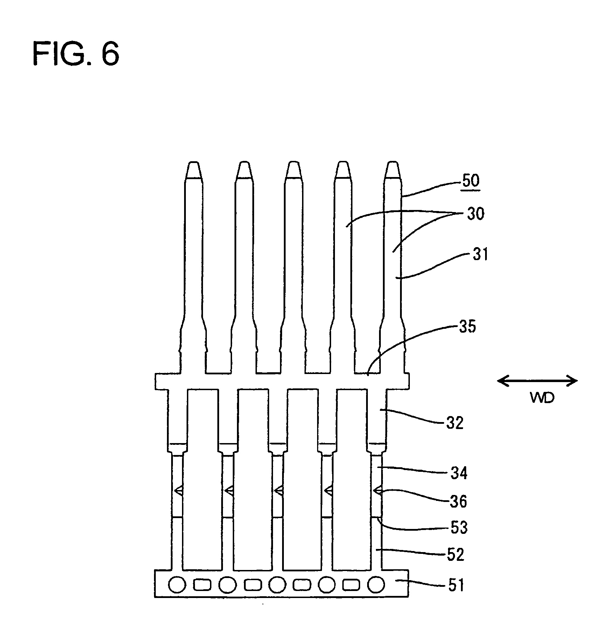

Particularly, with the terminal fittings 30 mounted in the housing 10, parts of the terminal fittings 30 exposed outside the housing 10 at the first (upper) stage and those of the terminal fittings 30 exposed outside the housing 10 at the second (lower) stage preferably are offset to each other substantially in width direction WD, and/or the rear ends of the board connecting portions 34 of the terminal fittings 30 at the first and second (upper and lower stages) are substantially aligned substantially at the same position with respect to forward and backward directions FBD. On the other hand, the terminal connecting portions 31 of the terminal fittings 30 at the first and second (upper and lower) stages are substantially aligned at the same positions in width direction WD. Thus, the terminal connecting portions 31 and the horizontal portions 32 preferably are offset substantially in width direction WD at boundary portions 35 therebetween (see FIG. 6). Further, the horizontal portions 32, the vertical portions 33 and the board connecting portions 34 are protected from interference in width direction WD from the outer sides by one or more, preferably a pair of protection walls 17 projecting backward from the (preferably substantially opposite) widthwise end(s) of the receptacle 12.

As shown in FIG. 4, at least one notch 36 (as a preferred recessed portion) is formed at or near a corner portion 38 at one side (right side in FIG. 1) of a lateral edge portion 37 (longitudinal side surface portion) of the board connecting portion 34. The notch 36 is, in one of the two possibilities of the invention, formed by striking the corner portion 38 from an oblique lateral (upper) side, makes openings in two surfaces (e.g. the upper surface and one side surface e.g. the right surface) of the board connecting portion 34, and preferably is substantially V-shaped gradually opened toward the corner portion 38. This notch 36 preferably has such a depth that the bottom edge thereof substantially reaches the lower surface of the board connecting portion 34 (or substantially to the surface of the board connecting portion 34 substantially facing the printed circuit board K), and/or is gradually widened from this bottom edge toward the upper edges.

One or more slants 39 (being preferably sloped in a direction away from the circuit board's surface), i.e. the inner surfaces of the notch 36 (as a preferred recessed portion), are slanted surfaces that preferably are substantially symmetric with respect to forward and backward directions FBD with a cut-in line 41 extending obliquely to vertical direction VD (or to the normal vector N of the circuit board's surface) and sloped up along directions away from the cut-in line 41. In other words, the normal vectors to the surfaces of the slants 39 are arranged at an angle different from 0° or 180°, preferably substantially at an angle in the range of about 20° to 60° to the normal vector N of the circuit board's surface. The notches 36 preferably extend over a width which is more than about one third, more preferably more than about one half of the witch of the board connecting portion 34. The notches 36 preferably are substantially identically shaped in the respective board connecting portions 34, and preferably are aligned substantially at the same positions of the respective board connecting portions 34 with respect to forward and backward directions FBD. When soldering is applied to the board connecting portions 34 later, molten solder H flows at least partly into the notch(es) 36 as the preferred recessed portion(s) thereby flowing substantially upward substantially along the inner slants 39 to be adhered to the notches 36. The adhered state of the solder H can be seen from the outside. In other words, the notches 36 preferably may serve as solder testing portions.

Such terminal fittings 30 preferably are formed from chained terminals 50 obtained in a production process. As shown in FIG. 6, the chained terminals 50 are comprised of a carrier 51 extending substantially in width direction WD and the terminal fittings 30 (specifically, terminal fitting pieces as bases of the terminal fittings) projecting substantially side by side from one lateral edge of the carrier 51, wherein the terminal fittings 30 and the carrier 51 are coupled to each other by coupling portions 52 including sections that preferably become the board connecting portions 34 later. The terminal fittings 30 are cut off from the carrier 51 at cutting lines 53 located at longitudinal intermediate positions of the coupling portions 52. The board connecting portions 34 are formed as being cut off from the carrier 51, and rear end or distal surfaces 44 (extending end surfaces) of the board connecting portions 34 preferably are exposed as cut surfaces.

Next, functions of this embodiment thus constructed are described. First, the vertical portions 33 and the like are three-dimensionally bent and the notches 36 are formed preferably as a conductive (metal) sheet is punched or stamped out, whereby the chained terminals 50 shown in FIG. 6 are formed. Subsequently, plating such as tin, silver, gold or the like plating preferably is applied to the chained terminals 50, for example, by immersing the chained terminals 50 in plating solution and/or by galvanic deposition and then the coupling portions 52 are cut along the cutting lines 53 to separate the terminal fittings 30 from the carrier 51. Then, the rear end surfaces 44 of the board connecting portions 34 are left as unplated cut surfaces, whereas the other outer surfaces of the terminal fittings 30 are plated surfaces. However, it should be understood that the plating and cutting steps may be inversed, if desired. Thereafter, the respective terminal fittings 30 are at least partly inserted into the terminal insertion holes 13 of the housing 10 in the inserting direction, preferably substantially from behind, to be mounted.

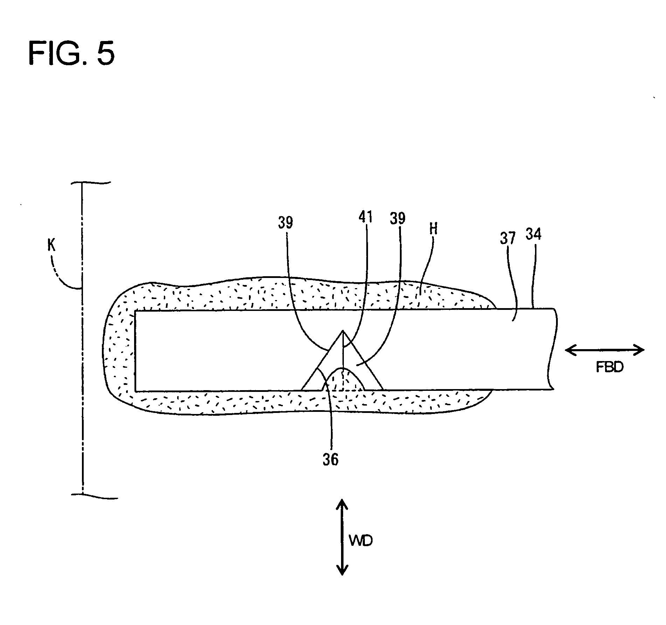

Subsequently, the one or more fixing portions 20 are mounted into the housing 10, which preferably is fixed to the circuit board K via the one or more fixing portions 20 preferably by soldering. Simultaneously or successively, the respective terminal fittings 30 are connected (preferably soldered or press-fitted). In other words, the board connecting portions 34 of the respective terminal fittings 30 are placed on the corresponding conductors on the circuit board K, and preferably solder H is adhered to the peripheral edge portions (extending end surfaces and the lateral edge portions 37) of the board connecting portions 34. Then, as shown in FIG. 5, part of the solder H at least partly enters the notch(es) 36 as the preferred recessed portion(s) thereby at least partly flowing or entering substantially upward along the slants 39 of the notches 36 and stops upon reaching a specified (predetermined or predeterminable) height as shown in FIG. 5. Thereafter, the adhered solder H is solidified, whereby the board connecting portions 34 are fixed to the circuit board K while being electrically connected with the conductors. The fixing operation to the circuit board K by means of the fixing portions 20 may be performed after the terminal fittings 30 are soldered and soldering preferably may be manual soldering or reflow soldering.

Subsequently, whether or not the connection by soldering at the board connecting portions 34 was proper is tested. The test is conducted by checking preferably by eye or by means of a camera whether or not the solder H flown into the notches 36 has reached a specified (predetermined or predeterminable) solder height by looking at the insides of the notches 36 formed in the lateral edge portions 37 of the board connecting portions 34 preferably substantially from above as shown in FIG. 5. Upon conducting the test, the view of an testing person is not blocked by the presence of the adjacent board connecting portions 34 and the housing 10, wherefore a good testing condition is ensured. It should be noted that the specified (predetermined or predeterminable) solder height is such a solder height set for quality control as to pass the test by indicating a proper amount of solder, and is set at intermediate positions of the slants 39 of the notches 36 or at the upper end positions of the slants 39.

If the amount of solder is judged to be proper by the test, the height of the upper surface of the solder H at the slants 39 is substantially same as or higher than the specified (predetermined or predeterminable) solder height, and a success in the test is judged by seeing or detecting such solder H. On the other hand, if the amount of solder is improper, the height of the upper surface of the solder H at the slants 39 is lower than the specified (predetermined or predeterminable) solder height, and a failure in the test is judged by seeing or detecting such solder H. Further, since the bottom edges of the slants 39 of the notches 36 preferably reach the lower surfaces of the board connecting portions 34, there is no likelihood that the solder H adheres to the slants 39 if soldering is not applied. The reliability of such a test preferably is improved by the plating applied to the slants 39 of the notches 36. Conversely, since the rear end surfaces 44 of the board connecting portions 34 preferably are unplated surfaces, the test cannot be conducted using these surfaces as testing surfaces.

As described above, according to this embodiment, the rear end surfaces 44 of the board connecting portions 34 can be unplated surfaces since the solder test preferably is conducted using the notches 36 formed in the lateral edge portions 37 of the board connecting portions 34. Accordingly, even if plating is applied to the chained terminals 50 in which the coupling portions 52 for coupling the terminal fittings 30 and the carrier 51 include the board connecting portions 34 as shown in FIG. 6 and then the coupling portions 52 are cut off to leave the rear end surfaces 44 of the board connecting portions 34 as cut surfaces, the test is not hindered. Thus, unlike the prior art shown in FIG. 7, it is not necessary to juxtapose the board connecting portions 34 in addition to the coupling portions 52. As a result, the terminals fittings 30 arranged at narrower intervals can be punched out from a metal sheet, thereby realizing the miniaturization and lower cost of the terminal fittings 30.

Since the bottom edges of the slants 39 of the notches 36 preferably reach the lower surfaces of the board connecting portions 34, a contact area of the solder H and the slants 39 is increased, wherefore the board connecting portions 34 are securely fixed to the circuit board K. Further, since no solder H is adhered to the bottom edges of the slants 39 unless plating is applied, whether or not plating has been applied preferably can be judged.

Accordingly, to narrow intervals between terminal fittings upon forming chained terminals and/or improving testability of soldering of terminal fittings to an electric or electronic device such as a printed circuit board, a connector is provided with a housing 10 and one or more terminal fittings 30 to be mounted in the housing 10. The terminal fittings 30 have respective board connecting portions 34 at parts preferably drawn out of the housing 10, and the board connecting portions 34 are arranged on the outer surface of an electric or electronic device such as a circuit board K and connected with conductors on the circuit board K preferably by soldering. One or more notches 36 formed with upward-sloped slants 39 (slants being sloped in a direction away from the circuit board's surface) to which solder H applied to the conductors at least partly are adhered are formed in or near or at lateral edge portions 37 of the board connecting portions 34. A solder test may be conducted by seeing or detecting the adhered state of the solder H to the slants 39 of the notches 36 preferably substantially from above (or in a range of visibility of about +/- 20° to the normal vector N of the surface of the electric/electronic device where the board connecting portions 34 are to be soldered). Since rear end surfaces 44 of the board connecting portions 34 preferably can be unplated surfaces, the board connecting portions 34 can be included in coupling portions 52 substantially continuous with a carrier 51 upon forming chained terminals 50.

### <Second Embodiment>

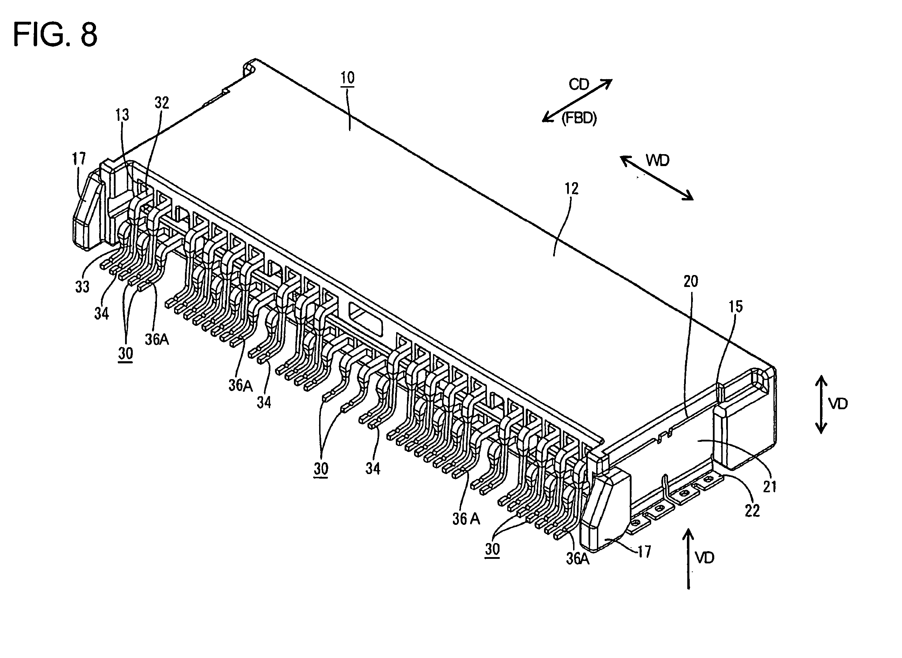

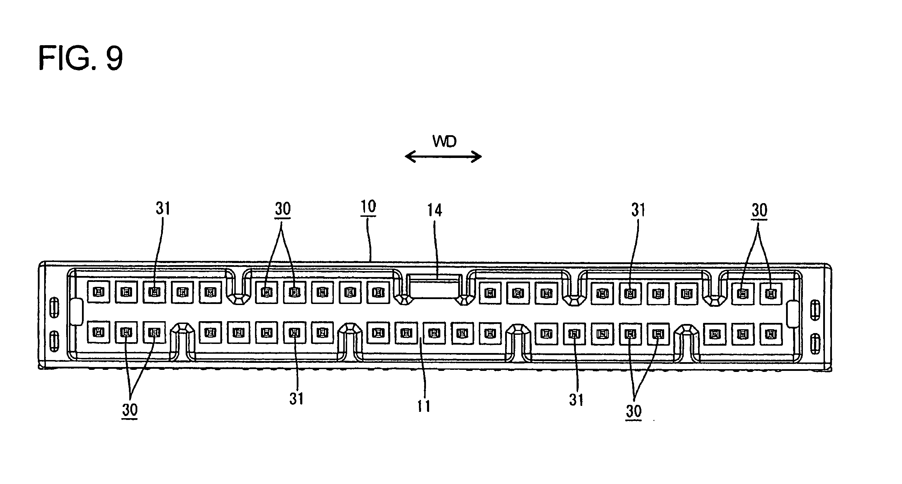

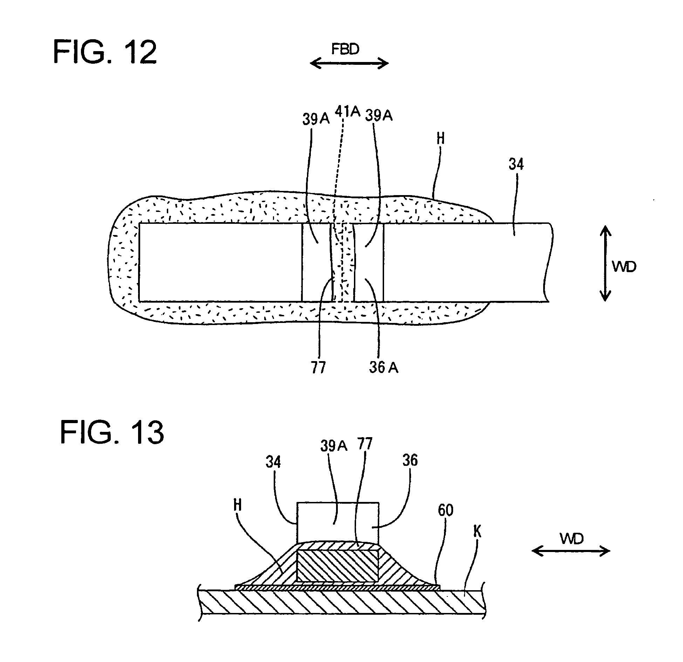

A second preferred embodiment of the present invention is described with reference to FIGS. 8 to 13. The second embodiment differs from the first embodiment substantially in the constitution of the recessed portion. The other features are similar or substantially same as the ones of the first embodiment and a repetitive description thereof will be omitted by denoting them with the same reference numerals similar to the first embodiment, the horizontal portions 32, the vertical portions 33 and the board connecting portions 34 (as the preferred device connecting board) are all arranged while being at least partly exposed outside the housing 10, wherein the board connecting portions 34 are at least partly arranged substantially along the outer surface of the circuit board K and electrically connectable with conductors 60 (electrode lands formed at ends of circuits in FIG. 13) printed or provided on the circuit board K by soldering while preferably being resiliently held in contact therewith.

With the terminal fittings 30 at least partly mounted in the housing 10, parts of the terminal fittings 30 substantially exposed outside the housing 10 at the first (upper) stage and those of the terminal fittings 30 exposed outside the housing 10 at the second (lower) stage are offset to each other in width direction WD, and the rear ends of the board connecting portions 34 of the terminal fittings 30 at the first and second (upper and lower) stages preferably are substantially aligned substantially at the same position with respect to forward and backward directions FBD. On the other hand, the terminal connecting portions 31 of the terminal fittings 30 at the first and second (upper and lower) stages preferably are substantially aligned at the same positions in width direction WD. Thus, the terminal connecting portions 31 and the horizontal portions 32 preferably are offset in width direction WD at boundary portions (not shown) therebetween. Further, the horizontal portions 32, the vertical portions 33 and the board connecting portions 34 are protected from interference in width direction WD from the outer sides by one or more, preferably a pair of protection walls 17 projecting backward from the (preferably substantially opposite) widthwise end(s) of the receptacle 12.

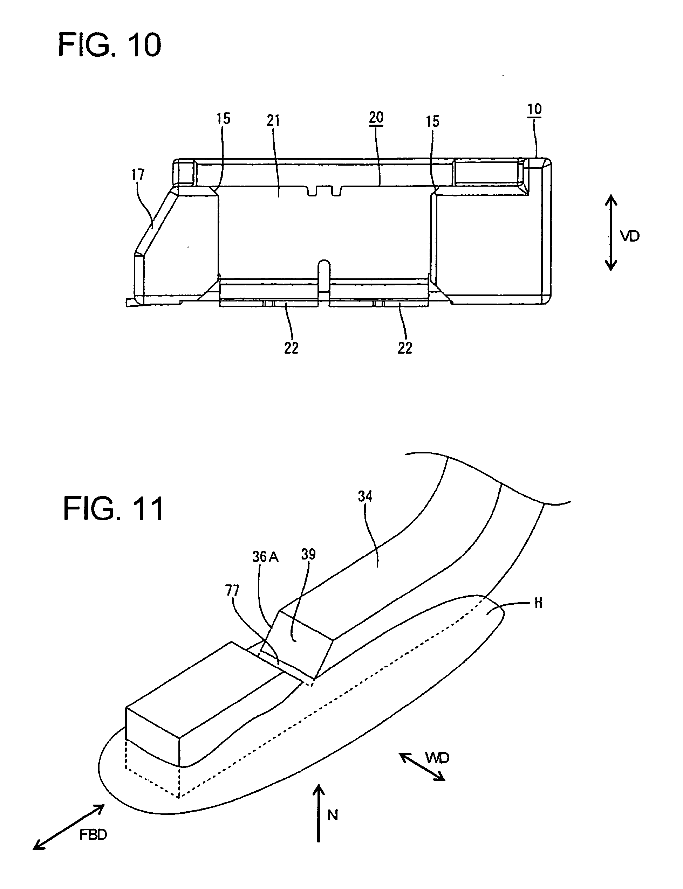

As shown in Fig. 11, each board connecting portion 34 has at least one recess 36A as a preferred recessed portion formed in the upper surface thereof (or in a surface substantially opposite to the one facing towards the circuit board K). This recess 36A (as the preferred recessed portion) is, in one of the two possibilities of the invention, formed by striking the upper surface of the board connecting portion 34 (or surface substantially opposite to the surface to be arranged substantially facing to the circuit board K) from above to make a cut (notch), and is continuously open in the upper surface of the board connecting portion 34 preferably over the entire width and/or substantially continuous with the opposite side surfaces at the opposite sides of this upper surface. The recess 36A has slants 39A preferably substantially symmetrical in forward and backward directions FBD with respect to a cut-in line 41A extending substantially in width direction WD, wherein the slants 39A preferably form a substantially V-shape by gradually widening a space therebetween in a direction away from the cut-in line 41A. In other words, the cut-in line 41A preferably is normal to the normal vector N of the circuit board's surface. Moreover, the slants 39A are arranged at an angle different from 0° or 180°, preferably substantially at an angle in the range of about 20° to 60° to the normal vector N of the circuit board's surface. The depths (vertical distance between the upper surface of the board connecting portion 34 to the cut-in line 41A) of the recesses 36A are preferably more than about one third, preferably about half the thickness or more, i.e. height of the board connecting portions 34, and/or the respective recesses 36A preferably are substantially identically shaped in the board connecting portions 34. Further, the positions of the recesses 36A preferably are substantially aligned substantially at the same positions of the board connecting portions 34 with respect to forward and backward directions FBD, so that the cut-in lines 41A are substantially aligned on a straight line in width direction WD.

The recesses 36A (as preferred recessed portions) permit solder H applied to the conductors to at least partly flow thereinto, and the slants 39A thereof function as a path for guiding the flow of the solder H. When flowing into the recesses 36A, the solder H preferably adheres between the opposite side surfaces of the board connecting portions 34 in the recesses 36A, thereby forming one or more bridges 77. These bridges 77 function as hooks for preventing upward displacements of the board connecting portions 34 (or displacements substantially away from the printed circuit board K). When the solder H further flows into the recesses 36A, the outer surfaces of the board connecting portions 34 corresponding to the recesses 36A are covered by the solder H, thereby being strongly held onto the conductors 60.

Next, functions of this embodiment thus constructed are described. First, the respective one or more terminal fittings 30 are at least partly inserted through the terminal insertion holes 13 of the housing 10 to be mounted.

Subsequently, the fixing portions 20 are at least partly mounted into the housing 10, and the housing 10 is fixed to the circuit board K via the fixing portions 20 preferably by soldering. Simultaneously or successively, the respective one or more terminal fittings 30 are soldered. More specifically, the board connecting portions 34 of the respective terminal fittings 30 are at least partly placed on the corresponding conductors 60 on the circuit board K and the solder H is adhered to the peripheral portions of the board connecting portions 34. Then, as shown in FIGS. 11 and 12, the solder H preferably is adhered from the opposite side surfaces to the rear end surfaces of the board connecting portions 34, and caused to laterally at least partly flow into the recesses 36A (preferably from the substantially opposite sides of the board connecting portions 34) along the bottom surfaces of the recesses 36A, thereby spreading in width direction WD in the recesses 36A preferably substantially between the substantially opposite side surfaces of the connecting portions 34.

Thereafter, when the solder H is solidified, the bridges 77 preferably are formed by the solder H between the substantially opposite side surfaces of the board connecting portions 34, whereby the board connecting portions 34 are fixed to the circuit board K while being electrically connected with the conductors 60. It should be noted that the fixing operation to the circuit board K by means of the fixing portions 20 may be performed after the terminal fittings 30 are soldered and soldering may be manual soldering or reflow soldering.

As described above, according to this embodiment, the recesses 36A are formed in the upper surfaces of the board connecting portions 34 (surfaces substantially opposite to the surfaces of the board connecting portions 34 substantially facing the circuit board K) and the solder H applied to the conductors 60 flows into these recesses 36A and is solidified, wherefore the board connecting portions 34 can be held onto the circuit board K (conductors 60) with enhanced forces. Accordingly, even if a tensile force acts on the board connecting portions 34 in upward direction (or direction substantially away from the circuit board K), the board connecting portions 34 are caught or retained by the solder H at least partly flown into the recesses 36A and can resist such a tensile force. Particularly, when the bridges 77 are formed from one lateral side to the other of the board connecting portion(s) 34 the retaining force is particularly strong. Thus, detachments of the board connecting portions 34 from the conductors 60 can be prevented. As a result, connection reliability can be secured between the board connecting portions 34 and the conductors 60.

When the solder H at least partly flows into the recess(es) 36A (as the preferred recessed portion(s)) and is solidified, it adheres to preferably stretch between the substantially opposite side surfaces of the board connecting portions 34 in the recesses 36A, thereby preferably forming the bridges 77. Thus, the board connecting portions 34 are securely fixed to the circuit board K. Further, the recesses 36A can be easily processed by preferably striking the upper surfaces of the board connecting portions 34 to make cuts.

Accordingly, to secure connection reliability between board connecting portions and conductors, a connector for an electric or electronic device such as a printed circuit board is provided with a housing 10 and one or more terminal fittings 30 to be at least partly mounted in the housing 10. The terminal fittings 30 have board connecting portions 34 (as preferred device connecting portions) at or near parts drawn out of the housing 10, and the board connecting portions 34 are at least partly arranged substantially on the outer surface of a circuit board K and connected with conductors 60 on the circuit board K by soldering. On or more recesses 36A (as preferred recessed portions) for permitting solder H applied to conductors 60 to at least partly flow thereinto are formed in the upper surfaces (or surface substantially opposite to the surface substantially facing the circuit board K) of the board connecting portions 34. The recesses 36A extend preferably across the upper surfaces of the board connecting portions 34 in width direction WD, and preferably make openings in side surfaces at the substantially opposite sides of the upper surfaces. Since an upward tensile force acting on the board connecting portions 34 can be resisted by the solder flown into the recesses 36A, detachments of the board connecting portions 34 from the conductors 60 can be prevented.

### <Other Embodiments>

The present invention is not limited to the above described and illustrated embodiment. For example, the following embodiments are also embraced by the technical scope of the present invention as defined by the claims. Beside the following embodiments, various changes can be made without departing from the scope of the present invention as defined by the claims.
(1) Although the solder testing portions are the notches formed in the lateral edge portions of the board connecting portions in the foregoing embodiment, it is sufficient to form the lateral edge portion of each board connecting portion with a solder testing portion having an upward sloped slant that can be seen from the outside according to the present invention. For example, the board connecting portion may be substantially entirely formed to have such a trapezoidal cross section whose upper side is shorter than the lower side.
(2) In the present invention, the slants of the solder testing portions may be colored in such a color having a clear contrast with the solder.
(3) The shape of the terminal fittings is not limited to the substantial L-shape and may, for example, be straight from the terminal connecting portions to the board connecting portions.
(4) The terminal fittings may be mounted in the housing by insert molding.
(5) It is not necessary to fix the housing to the circuit board using the fixing portions. For example, the housing may be fixed by means of screws.
(6) The recesses 36A need not make openings substantially continuous over the entire widths of the upper surfaces of the board connecting portions, and it is sufficient that cuts are made to make openings in the upper and side surfaces of the board connecting portions.
(7) The recesses 36, 36A need not to be V-shaped cuts and, for example, may be substantially box-shaped dents defined by substantially horizontal walls and substantially vertical walls.
(8) Although in the above preferred embodiment the notches 36 are provide on one side of the board connection portion 34 only, they made be provided on both side. Moreover, notches 36 being provided on substantially opposite sides may be interconnected while forming a (preferably substantially pointed) sloped portion therebetween the apex of which is lower than the upper surface of the board connecting portion 34.
(9) The present invention is also applicable to connectors to be fixed to electric or electronic devices other than printed circuit boards such as junction boxes, dashboard panels, fuse boxes, relais boxes or the like.

### LIST OF REFERENCE NUMERALS

- 10 ...: housing
- 12 ...: receptacle
- 20 ...: fixing portion
- 30 ...: terminal fitting
- 32 ...: horizontal portion
- 33 ...: vertical portion
- 34 ...: board connecting portion (device connecting portion)
- 36 ...: notch (solder testing portion or recessed portion)
- 36A ...: recess (recessed portion)
- 39, 39A ...: slant or slanted surface
- 41, 41A ...: cut-in line
- 60 ...: conductor
- 77 ....: bridge
- K ...: printed circuit board (electric/electronic device)

## Claims

1. A connector for an electric or electronic device such as a printed circuit board (K), comprising:
a housing (10) to be fixed to an electric or electronic device such as a circuit board (K), and
one or more terminal fittings (30) to be at least partly mounted in the housing (10), each terminal fitting (30) including a device connecting portion (34) at a part thereof drawn out of the housing (10), wherein the lower surface of the device connecting portion (34) is to be arranged on the electric or electronic device (K) and to be connected with a corresponding conductor (60) thereon by soldering,
wherein one or more recess portions (36; 36A) for guiding the flow of solder (H) applied to the conductors (60) at least partly thereinto are formed in the device connecting portions (34),
**characterized in that**
the recessed portion (36) is formed by striking a corner portion (38) of the device connecting portions (34) from an oblique lateral side or the recesses (36A) are formed by striking the upper surfaces of the device connecting portions (34) substantially from above.

2. A connector according to claim 1,
wherein the recessed portions (36; 36A) comprise one or more solder testing portions (36) having upward-sloped slants (39) to which solder (H) applied to the conductors is to be at least partly adhered are formed at lateral edge portions of the device connecting portions (34), the height of the upper surface of the solder (H) is to be defined within a height range of the slants (39), and an adhered state of the solder (H) to the slants (39) can be seen from the outside.

3. A connector according to claim 2, wherein the solder testing portions (36) are formed by making oblique cuts in the lateral edge portions (38) of the device connecting portions (34), and the inner surfaces of the cuts serve as the slants (39).

4. A connector according to claim 2 or 3, wherein the bottom edges of the slants (39) in the solder testing portions (36) extend substantially up to the lower surfaces of the device connecting portions (34).

5. A connector according to one or more of the preceding claims, wherein slants (39; 39A) of the recessed portions (36; 36A) are be colored in such a color having a clear contrast with the solder (H).

6. A connector according to one or more of the preceding claims, wherein slants (39; 39A) of the recessed portion (36; 36A) are substantially symmetric with respect to forward and backward directions (FBD).

7. A connector according to one or more of the preceding claims, wherein the recessed portion (36) is formed with a cut-in line (41) extending obliquely to a normal vector (N) of the circuit board's surface and sloped up along directions away from the cut-in line (41).

8. A circuit board connector according to one or more of the preceding claims, wherein the recess portions (36; 36A) comprise one or more recesses (36; 36A) provided on the surface of the device connecting portion (34) substantially opposite to the surface to be faced to the electric or electronic device (K).

9. A connector according to claim 8, wherein the recesses (36A) extend across the upper surfaces of the device connecting portions (34) and make openings in side surfaces at the substantially opposite sides of the upper surfaces.

10. A terminal fitting (30) for a connector to be mounted on an electric or electronic device such as a printed circuit board (K), the terminal fitting (30) comprising:
a device connecting portion (34) at a part thereof drawn out of a housing (10) of the connector, the device connecting portion (34) being provided to be at least partly arranged substantially along the outer surface of the electric or electronic device (K) and to be connected with a corresponding conductor on the electric or electronic device (K) by soldering, and
one or more recess portions (36; 36A) for guiding the flow of solder (H) applied to the conductors (60) at least partly thereinto are formed in the device connecting portions (34),
**characterized in that**
the recessed portion (36) is formed by striking a corner portion (38) of the device connecting portions (34) from an oblique lateral side or the recesses (36A) are formed by striking the upper surfaces of the device connecting portions (34) substantially from above.

11. A terminal fitting according to claim 10, wherein the recessed portion (36; 36A) comprises one or more solder testing portions (36) having upward-sloped slants (39) to which solder (H) applied to the conductors is to be at least partly adhered, the solder testing portions (36) being formed at lateral edge portions of the device connecting portions (34), the height of the upper surface of the solder (H) is to be defined within a height range of the slants (39), and an adhered state of the solder (H) to the slants (39) can be seen from the outside.

12. A terminal fitting according to claim 10 or 11, wherein the recess portions (36; 36A) comprise one or more recesses (36; 36A) provided on the surface of the device connecting portion (34) substantially opposite to the surface to be faced to the electric or electronic device (K).

13. Chained terminals (50) comprising a carrier (51) extending and a plurality of terminal fittings (30) according to one or more of the preceding claims 10 to 12, which project substantially side by side from at least one lateral edge of the carrier (51).

14. A method of mounting a connector to an electric or electronic device such as a printed circuit board (K), comprising the following steps:
providing a housing (10) to be fixed to an electric or electronic device such as a circuit board (K);
at least partly mounting one or more terminal fittings (30) in the housing (10), each terminal fitting (30) including a device connecting portion (34) at a part thereof drawn out of the housing (10);
at least partly arranging the device connecting portion (34) substantially along the outer surface of the electric or electronic device (K);
connecting the device connecting portion (34) with a corresponding conductor on the electric or electronic device (K) by soldering thereby at least partly applying solder (H) to one or more recessed portions (36; 36A) of the device connecting portion (34),
**characterized by**
forming the recessed portion (36) by striking a corner portion (38) of the device connecting portions (34) from an oblique lateral side or forming the recesses (36A) by striking the upper surfaces of the device connecting portions (34) substantially from above.

15. A method according to claim 14, wherein in the connecting step solder (H) is applied to one or more solder testing portions (36) of the recessed portion (36; 36A) having upward-sloped slants (39) formed at lateral edge portions (38) of the device connecting portions (34), the height of the upper surface of the solder (H) being defined within a height range of the slants (39).

16. A method according to claim 14 or 15, further comprising a step of inspecting an adhered state of the solder (H) to the recessed portion (36; 36A), preferably to the slants (39).

17. A method according to one or more of the preceding claims 14 to 16, wherein in the soldering step solder (H) applied to the conductors (60) is guided at least partly into one or more recesses (36A) of the recessed portion(s) (36; 36A), the recesses (36A) being formed in upper surfaces of the device connecting portions (34), preferably so as to extend substantially across the upper surfaces of the device connecting portions (34) and make openings in side surfaces at the opposite sides of the upper surfaces.

## Patentansprüche

1. Verbinder für eine elektrische oder elektronische Vorrichtung, wie einer gedruckten Leiterplatte (K), umfassend:
ein Gehäuse (10), das einer elektrischen oder elektronischen Vorrichtung, wie einer Leiterplatte (K) zu fixieren bzw. zu befestigen ist, und
ein oder mehreren Anschlusspassstücke bzw. -kontakte (30), die zumindest teilweise in dem Gehäuse (10) zu montieren sind, wobei jedes Anschlusspassstück (30) einen Vorrichtungsverbindungabschnitt (34) an einem Teil davon enthält, der aus dem Gehäuse (10) herausgezogen ist, wobei die untere Fläche bzw. Oberfläche des Vorrichtungsverbindungabschnitts (34) an der elektrischen oder elektronischen Vorrichtung (K) anzuordnen und mit einem entsprechenden Leiter (60) darauf bzw. daran durch Löten zu verbinden ist,
wobei ein oder mehrere Aussparungsabschnitte (36; 36A), die den Lötmittelstroms (H), der auf die Leiter (60) aufgebracht wird, zumindest teilweise in diese hineinführen, in den Vorrichtungsverbindungabschnitten (34) gebildet sind,
**dadurch gekennzeichnet, dass**
der ausgesparte Abschnitt (36) durch Ab- bzw. Anschlagen eines Eckabschnitts (38) der Vorrichtungsverbindungabschnitte (34) von einer schrägen, lateralen Seiten gebildet wird oder die Aussparungen (36A) durch Ab- bzw. Anschlagen der oberen Flächen bzw. Oberflächen der Vorrichtungsverbindungabschnitte (34) im Wesentlichen von oben gebildet werden.

2. Verbinder nach Anspruch 1, wobei die ausgesparten Abschnitte (36; 36A) einen oder mehrere Lötmitteltestabschnitte (36) mit nach oben geneigten Schrägen (39) umfassen, an denen Lötmittel (H), das auf die Leiter aufgebracht wird, zumindest teilweise anzuhaften ist, wobei die Lötmitteltestabschnitte (36) an den lateralen Rand- bzw. Kantenabschnitten der Vorrichtungsverbindungabschnitte (34) gebildet sind, die Höhe der oberen Oberfläche des Lötmittels (H) innerhalb eines Höhenbereichs der Schrägen (39) zu definieren ist und ein angehafteter Zustand bzw. Haftzustand des Lötmittels (H) an den Schrägen (39) von außen gesehen werden kann.

3. Verbinder nach Anspruch 2, wobei die Lötmitteltestabschnitte (36) gebildet werden, indem schräge Schnitte in die lateralen Kantenabschnitt (38) der Vorrichtungsverbindungabschnitte (34) gemacht werden und die inneren Oberflächen der Schnitte als die Schrägen (39) dienen.

4. Verbinder nach Anspruch 2 oder 3, wobei sich die Bodenkanten bzw. -ränder der Schrägen (39) in den Lötmitteltestabschnitten (36) im Wesentlichen bis zu den unteren Oberflächen der Vorrichtungsverbindungabschnitte (34) erstrekken.

5. Verbinder nach einem oder mehreren der vorhergehenden Ansprüche, wobei Schrägen (39; 39A) der ausgesparten Abschnitte (36; 36A) in einer solchen Farbe einzufärben sind, die einen klaren Kontrast zu dem Lötmittel (H) aufweist.

6. Verbinder nach einem oder mehreren der vorhergehenden Ansprüche, wobei Schrägen (39; 39A) der ausgesparten Abschnitte (36; 36A) im Wesentlichen bezüglich Vorwärts- und Rückwärtsrichtung (FBD) symmetrisch sind.

7. Verbinder nach einem oder mehreren der vorhergehenden Ansprüche, wobei der ausgesparte Abschnitt (36) mit einer Einschnittslinie (41) gebildet ist, die sich schräg zu einem Normalenvektor (N) der Oberfläche der Leiterplatte erstreckt, und der entlang Richtungen weg von der Einschnittslinie (41) nach oben geneigt ist.

8. Verbinder nach einem oder mehreren der vorhergehenden Ansprüche, wobei die Aussparungsabschnitte (36; 36A) eine oder mehrere Aussparungen (36; 36A) umfassen, die an der Oberfläche des Vorrichtungsverbindungabschnitts (34) im Wesentlichen gegenüberliegend bzw. entgegengesetzt zu der Oberfläche vorgesehen sind, die der elektrischen oder elektronischen Vorrichtung (K) zugewandt sein soll bzw. zuzuwenden ist.

9. Verbinder nach Anspruch 8, wobei sich die Aussparungen (36A) über die oberen Oberflächen der Vorrichtungsverbindungabschnitte (34) erstrecken und Öffnungen in Seitenflächen bzw. -oberflächen an den im Wesentlichen gegenüberliegenden bzw. entgegengesetzten Seiten der oberen Oberflächen machen bzw. bilden.

10. Anschlusspassstück bzw. -kontakt (30) für einen Verbinder, der an einer elektrischen oder elektronischen Vorrichtung, wie einer gedruckten Leiterplatte (K) zu montieren ist, wobei das Anschlusspassstück (30) umfasst:
einen Vorrichtungsverbindungabschnitt (34) an einem Teil davon, der aus einem Gehäuse (10) des Verbinders herausgezogen ist, wobei der Vorrichtungsverbindungabschnitt (34) vorgesehen ist, um zumindest teilweise im Wesentlichen entlang der äußeren Fläche bzw. Oberfläche der elektrischen oder elektronischen Vorrichtung (K) angeordnet zu werden und mit einem entsprechenden Leiter (60) an der elektrischen oder elektronischen Vorrichtung (K) durch Löten verbunden zu werden, und
wobei ein oder mehrere Aussparungsabschnitte (36; 36A), die den Lötmittelstroms (H), der auf die Leiter (60) aufgebracht wird, zumindest teilweise in diese hineinführen, in den Vorrichtungsverbindungabschnitten (34) gebildet sind,
**dadurch gekennzeichnet, dass**
der ausgesparte Abschnitt (36) durch Ab- bzw. Anschlagen eines Eckabschnitts (38) der Vorrichtungsverbindungabschnitte (34) von einer schrägen, lateralen Seiten gebildet wird oder die Aussparungen (36A) durch Ab- bzw. Anschlagen der oberen Flächen bzw. Oberflächen der Vorrichtungsverbindungabschnitte (34) im Wesentlichen von oben gebildet werden.

11. Anschlusspassstück nach Anspruch 10, wobei die ausgesparten Abschnitte (36; 36A) einen oder mehrere Lötmitteltestabschnitte (36) mit nach oben geneigten Schrägen (39) umfassen, an denen Lötmittel (H), das auf die Leiter aufgebracht wird, zumindest teilweise anzuhaften ist, wobei die Lötmitteltestabschnitte (36) an den lateralen Rand- bzw. Kantenabschnitten der Vorrichtungsverbindungabschnitte (34) gebildet sind, die Höhe der oberen Oberfläche des Lötmittels (H) innerhalb eines Höhenbereichs der Schrägen (39) zu definieren ist und ein angehafteter Zustand bzw. Haftzustand des Lötmittels (H) an den Schrägen (39) von außen gesehen werden kann.

12. Anschlusspassstück nach Anspruch 10 oder 11, wobei die Aussparungsabschnitte (36; 36A) eine oder mehrere Aussparungen (36; 36A) umfassen, die an der Oberfläche des Vorrichtungsverbindungabschnitts (34) im Wesentlichen gegenüberliegend bzw. entgegengesetzt zu der Oberfläche vorgesehen sind, die der elektrischen oder elektronischen Vorrichtung (K) zugewandt sein soll bzw. zuzuwenden ist.

13. Verkettete Anschlüsse (50), umfassend eine Träger(51)-Erstreckung bzw. Verlängerung und eine Mehrzahl von Anschlusspassstücken bzw. -kontakten (30) nach einem oder mehreren der vorhergehenden Ansprüche 10 bis 12, die im Wesentlichen Seite an Seite von zumindest einer lateralen Kante bzw. Rand des Trägers (51) vorragen.

14. Verfahren zum Montieren eines Verbinders an einer elektrischen oder elektronischen Vorrichtung, wie einer gedruckten Leiterplatte (K), umfassend die folgenden Schritte:
Bereitstellen eines Gehäuses (10), das einer elektrischen oder elektronischen Vorrichtung, wie einer Leiterplatte (K) zu fixieren bzw. zu befestigen ist, zumindest teilweises Montieren eines oder mehrerer Anschlusspassstücke bzw. -kontakte (30) in dem Gehäuse (10), wobei jedes Anschlusspassstück (30) einen Vorrichtungsverbindungabschnitt (34) an einem Teil davon enthält, der aus dem Gehäuse (10) herausgezogen ist,
zumindest teilweises Anordnen des Vorrichtungsverbindungabschnitts (34) im Wesentlichen entlang der äußeren Fläche bzw. Oberfläche der elektrischen oder elektronischen Vorrichtung (K);
Verbinden des Vorrichtungsverbindungabschnitts (34) mit einem entsprechenden Leiter (60) an der elektrischen oder elektronischen Vorrichtung (K) durch Löten, **dadurch** zumindest teilweise Aufbringen von Lötmittel (H) an bzw. auf einen oder mehrere der ausgesparten Abschnitte (36; 36A) des Vorrichtungsverbindungabschnitts (34),
**gekennzeichnet durch**
Bilden des ausgesparten Abschnitts (36) **durch** Ab- bzw. Anschlagen eines Eckabschnitts (38) der Vorrichtungsverbindungabschnitte (34) von einer schrägen, lateralen Seiten oder Bilden der Aussparungen (36A) **durch** Ab- bzw. Anschlagen der oberen Flächen bzw. Oberflächen der Vorrichtungsverbindungabschnitte (34) im Wesentlichen von oben.

15. Verfahren nach Anspruch 14, wobei in dem Verbindungsschritt Lötmittel (H) auf einen oder mehrere Lötmitteltestabschnitte (36) des ausgesparten Abschnitts (36; 36A) aufgebracht wird, die nach oben geneigte Schrägen (39) aufweisen, die an lateralen Kanten- bzw. Randabschnitten (38) der Vorrichtungsverbindungabschnitte (34) gebildet sind, wobei die Höhe der oberen Oberfläche des Lötmittels (H) innerhalb eines Höhenbereichs der Schrägen (39) definiert ist.

16. Verfahren nach Anspruch 14 oder 15, ferner umfassend einen Schritt des Inspizierens eines angehafteten Zustands bzw. Haftzustands des Lötmittels (H) an dem ausgesparten Abschnitt (36; 36A), vorzugsweise an den Schrägen (39).

17. Verfahren nach einem oder mehreren der vorhergehenden Ansprüche 14 bis 16, wobei in dem Lötschritt Lötmittel (H), das auf die Leiter (60) aufgebracht wird, zumindest teilweise in eine oder mehreren Aussparungen (36A) des/der ausgesparten Abschnitts/Abschnitte (36; 36A) geführt wird, wobei die Aussparungen (36A) in oberen Flächen bzw. Oberflächen der Vorrichtungsverbindungabschnitte (34) gebildet sind, vorzugsweise um sich im Wesentlichen über die oberen Oberflächen der Vorrichtungsverbindungabschnitte (34) zu erstrecken und Öffnungen in Seitenflächen bzw. -oberflächen an den gegenüberliegenden bzw. entgegengesetzten Seiten der oberen Oberflächen zu machen bzw. zu bilden.

## Revendications

1. Connecteur pour un dispositif électrique ou électronique tel qu'un circuit imprimé (K), comprenant :
un boîtier (10) destiné à être fixé à un dispositif électrique ou électronique tel qu'un circuit imprimé (K), et
un ou plusieurs organes de contact (30) destinés à être au moins en partie montés dans le boîtier (10), chaque organe de contact (30) comprenant une portion de connexion de dispositif (34) sur une partie de celui-ci sortie du boîtier (10), dans lequel la surface inférieure de la portion de connexion de dispositif (34) est destinée à être agencée sur le dispositif électrique ou électronique (K) et à être connectée à un conducteur correspondant (60) sur celui-ci par soudage,
dans lequel une ou plusieurs portions d'évidement (36 ; 36A) pour guider l'écoulement du métal d'apport (H) appliqué aux conducteurs (60) au moins en partie dans celles-ci sont formées dans les portions de connexion de dispositif (34),
**caractérisé en ce que**
la portion évidée (36) est formée en frappant une portion de coin (38) des portions de connexion de dispositif (34) depuis un côté latéral oblique ou les évidements (36A) sont formés en frappant les surfaces supérieures des portions de connexion de dispositif (34) sensiblement par le haut.

2. Connecteur selon la revendication 1,
dans lequel les portions évidées (36 ; 36A) comprennent une ou plusieurs portions de test de métal d'apport (36) présentant des pentes inclinées vers le haut (39) auxquelles du métal d'apport (H) appliqué aux conducteurs est destiné à en partie adhérer sont formées sur des portions de coin latérales des portions de connexion de dispositif (34), la hauteur de la surface supérieure du métal d'apport (H) est à définir comprise dans une plage de hauteur des pentes (39), et un état adhéré du métal d'apport (H) sur les pentes (39) peut être vu depuis l'extérieur.

3. Connecteur selon la revendication 2, dans lequel les portions de test de métal d'apport (36) sont formées en faisant des coupures obliques dans les portions de bord latérales (38) des portions de connexion de dispositif (34), et les surfaces intérieures des coupures servent de pentes (39).

4. Connecteur selon la revendication 2 ou 3, dans lequel les bords du fond des pentes (39) dans les portions de test de métal d'apport (36) s'étendent sensiblement jusqu'aux surfaces inférieures des portions de connexion de dispositif (34).

5. Connecteur selon l'une ou plusieurs des revendications précédentes, dans lequel des pentes (39 ; 39A) des portions évidées (36 ; 36A) sont colorées dans une couleur présentant un contraste net avec le métal d'apport (H).

6. Connecteur selon l'une ou plusieurs des revendications précédentes, dans lequel des pentes (39 ; 39A) des portions évidées (36 ; 36A) sont sensiblement symétriques par rapport à des directions vers l'avant et vers l'arrière (FBD).

7. Connecteur selon l'une ou plusieurs des revendications précédentes, dans lequel la portion évidée (36) est formée avec une ligne découpée (41) s'étendant obliquement par rapport à un vecteur normal (N) de la surface du circuit imprimé et inclinée vers le haut le long de directions s'éloignant de la ligne découpée (41).

8. Connecteur de circuit imprimé selon l'une ou plusieurs des revendications précédentes, dans lequel les portions d'évidement (36 ; 36A) comprennent un ou plusieurs évidements (36 ; 36A) fournis sur la surface de la portion de connexion de dispositif (34) sensiblement opposée à la surface destinée à faire face au dispositif électrique ou électronique (K).

9. Connecteur selon la revendication 8, dans lequel les évidements (36A) s'étendent à travers les surfaces supérieures des portions de connexion de dispositif (34) et font des ouvertures dans des surfaces de côté aux côtés sensiblement opposés des surfaces supérieures.

10. Organe de contact (30) pour un connecteur destiné à être monté sur un dispositif électrique ou électronique tel qu'un circuit imprimé (K), l'organe de contact (30) comprenant :
une portion de connexion de dispositif (34) sur une partie de celui-ci sortie d'un boîtier (10) du connecteur, la portion de connexion de dispositif (34) étant fournie pour être au moins en partie agencée sensiblement le long de la surface extérieure du dispositif électrique ou électronique (K) et pour être connectée à un conducteur correspondant sur le dispositif électrique ou électronique (K) par soudage, et
une ou plusieurs portions d'évidement (36 ; 36A) pour guider l'écoulement du métal d'apport (H) appliqué aux conducteurs (60) au moins en partie dans celles-ci sont formées dans les portions de connexion de dispositif (34),
**caractérisé en ce que**
la portion évidée (36) est formée en frappant une portion de coin (38) des portions de connexion de dispositif (34) depuis un côté latéral oblique ou les évidements (36A) sont formés en frappant les surfaces supérieures des portions de connexion de dispositif (34) sensiblement par le haut.

11. Organe de contact selon la revendication 10, dans lequel la portion évidée (36 ; 36A) comprend une ou plusieurs portions de test de métal d'apport (36) présentant des pentes inclinées vers le haut (39) auxquelles du métal d'apport (H) appliqué aux conducteurs est destiné à au moins en partie adhérer, les portions de test de métal d'apport (36) étant formées sur des portions de coin latérales des portions de connexion de dispositif (34), la hauteur de la surface supérieure du métal d'apport (H) est à définir comprise dans une plage de hauteur des pentes (39), et un état adhéré du métal d'apport (H) sur les pentes (39) peut être vu de l'extérieur.

12. Organe de contact selon la revendication 10 ou 11, dans lequel les portions d'évidement (36 ; 36A) comprennent un ou plusieurs évidements (36 ; 36A) fournis sur la surface de la portion de connexion de dispositif (34) sensiblement opposée à la surface destinée à faire face au dispositif électrique ou électronique (K).

13. Bandes de terminaux électriques (50) comprenant un support (51) s'étendant et une pluralité d'organes de contact (30) selon l'une ou plusieurs des revendications précédentes 10 à 12, qui dépassent sensiblement côte à côte d'au moins un bord latéral du support (51).

14. Procédé de montage d'un connecteur sur un dispositif électrique ou électronique tel qu'un circuit imprimé (K), comprenant les étapes suivantes :
fournir un boîtier (10) destiné à être fixé à un dispositif électrique ou électronique tel qu'un circuit imprimé (K) ;
au moins en partie monter un ou plusieurs organes de contact (30) dans le boîtier (10), chaque organe de contact (30) comprenant une portion de connexion de dispositif (34) sur une partie de celui-ci sortie du boîtier (10) ;
au moins en partie agencer la portion de connexion de dispositif (34) sensiblement le long de la surface extérieure du dispositif électrique ou électronique (K) ;
connecter la portion de connexion de dispositif (34) à un conducteur correspondant sur le dispositif électrique ou électronique (K) par soudage, appliquant ainsi au moins en partie du métal d'apport (H) sur une ou plusieurs portions évidées (36 ; 36A) de la portion de connexion de dispositif (34),
**caractérisé par** l'étape consistant à
former la portion évidée (36) en frappant une portion de coin (38) des portions de connexion de dispositif (34) depuis un côté latéral oblique ou former les évidements (36A) en frappant les surfaces supérieures des portions de connexion de dispositif (34) sensiblement par le haut.

15. Procédé selon la revendication 14, dans lequel dans l'étape de connexion, un métal d'apport (H) est appliqué à une ou plusieurs portions de test de métal d'apport (36) de la portion évidée (36 ; 36A) présentant des pentes inclinées vers le haut (39) formées sur des portions de bord latérales (38) des portions de connexion de dispositif (34), la hauteur de la surface supérieure du métal d'apport (H) étant définie comprise dans une plage de hauteur des pentes (39).

16. Procédé selon la revendication 14 ou 15, comprenant en outre une étape d'inspection d'un état adhéré du métal d'apport (H) sur la portion évidée (36 ; 36A), de préférence sur les pentes (39).

17. Procédé selon l'une ou plusieurs des revendications précédentes 14 à 16, dans lequel dans l'étape de soudage, un métal d'apport (H) appliqué aux conducteurs (60) est guidé au moins en partie dans un ou plusieurs évidements (36A) de la/des portion(s) évidée(s) (36 ; 36A), les évidements (36A) étant formés dans des surfaces supérieures des portions de connexion de dispositif (34), de préférence de façon à s'étendre sensiblement à travers les surfaces supérieures des portions de connexion de dispositif (34) et faire des ouvertures dans des surfaces de côté aux côtés opposés des surfaces supérieures.
